(19) Europäisches Patentamt

European Patent Office

Office européen des brevets

(11) **EP 1 193 883 A2**

(12) **EUROPEAN PATENT APPLICATION**

(43) Date of publication:
**03.04.2002 Bulletin 2002/14**

(51) Int Cl.[7]: **H03M 13/47**, G11B 20/18

(21) Application number: **01123157.8**

(22) Date of filing: **27.09.2001**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **29.09.2000 JP 2000298093**

(71) Applicant: **NEC CORPORATION**
**Tokyo (JP)**

(72) Inventor: **Mitsutani, Naoki**
**Tokyo (JP)**

(74) Representative: **Glawe, Delfs, Moll & Partner**
**Patentanwälte**
**Postfach 26 01 62**
**80058 München (DE)**

(54) **Correlation matrix learning method and apparatus, and storage medium therefor**

(57) In a correlation matrix learning method, calculation between a code word and a correlation matrix is performed. The calculation result is compared with a threshold value set for each component on the basis of an original code word. The correlation matrix is updated on the basis of the comparison result using an update value which changes stepwise. Learning of the correlation matrix including calculation, comparison, and update is performed for all code words, thereby obtaining an optimum correlation matrix for all the code words. A correlation matrix learning apparatus and storage medium are also disclosed.

FIG. 1

## Description

Background of the Invention

The present invention relates to a correlation matrix learning method and apparatus in a decoding scheme using a correlation matrix, and a storage medium therefor and, more particularly, to a correlation matrix learning method and apparatus in decoding a block code serving as an error-correcting code by using a correlation matrix.

Conventionally, in a decoding scheme of decoding a block code serving as an error-correcting code by using a correlation matrix, decoding is executed using a correlation matrix between an original code word before encoding and a code word after encoding. In this decoding scheme, a correlation matrix is obtained by learning. In a correlation matrix learning method, a code word after encoding and a correlation matrix are calculated, and each component of the calculation result is compared with a preset threshold value "±TH", thereby updating the correlation matrix. If a component of the original code word before encoding is "+1", a threshold value "+TH" is set. Only when the calculation result is smaller than "+TH", each component of the correlation matrix is updated by "±ΔW".

If a component of the original code word before encoding is "0", a threshold value "-TH" is set. Only when the calculation result is larger than "-TH", each component of the correlation matrix is updated by "±ΔW". This correlation matrix learning is repeated for all the code words and stopped at an appropriate number of times, thereby obtaining a correlation matrix.

In such a conventional correlation matrix learning method, since the number of times of learning at which the correlation matrix learning should be stopped is unknown, the learning is stopped at an appropriate number of times. Hence, a sufficient number of times of learning is required more than necessity to learn all code words, and a long time is required for learning. Even when a sufficient number of times of learning is ensured, for a certain code word, the calculation result only repeatedly increases or decreases from the threshold value "+TH" or "-TH" for a predetermined number of times or more, and correlation matrix learning is not actually executed for a predetermined number of times or more.

Additionally, since a value much smaller than the threshold value "TH" is set as an update value "ΔW" of a correlation matrix, a very large number of times of learning is required for correlation matrix learning to converge for all the code words. Furthermore, since no margin for a bit error of "± TH" is ensured for code words whose calculation results repeatedly increase or decrease from the threshold value "+TH" or "-TH", the error rate changes depending on the code word.

Summary of the Invention

It is an object of the present invention to provide a correlation matrix learning method and apparatus capable of quickly converging learning and a storage medium therefor.

It is another object of the present invention to provide a correlation matrix learning method and apparatus capable of obtaining an optimum correlation matrix for all code words and a storage medium therefor.

In order to achieve the above objects, according to the present invention, there is provided a correlation matrix learning method of obtaining an optimum correlation matrix by learning for a correlation matrix in a decoding scheme of obtaining an original code word from a code word, comprising the steps of performing calculation between the code word and the correlation matrix, comparing a calculation result with a threshold value set for each component on the basis of the original code word, updating the correlation matrix on the basis of a comparison result using an update value which changes stepwise, and performing learning of the correlation matrix including calculation, comparison, and update for all code words, thereby obtaining an optimum correlation matrix for all the code words.

Brief Description of the Drawings

Fig. 1 is a block diagram of a correlation matrix learning apparatus according to an embodiment of the present invention;
Fig. 2 is a view for explaining a correlation matrix learning rule in the correlation matrix learning apparatus shown in Fig. 1;
Fig. 3 is a view for explaining the range of calculation result input values to a comparison section when correlation matrix learning converges in the correlation matrix learning apparatus shown in Fig. 1; and
Fig. 4 is a flow chart showing the operation of the correlation matrix learning apparatus shown in Fig. 1.

Description of the Preferred Embodiment

The present invention will be described below in detail with reference to the accompanying drawings.

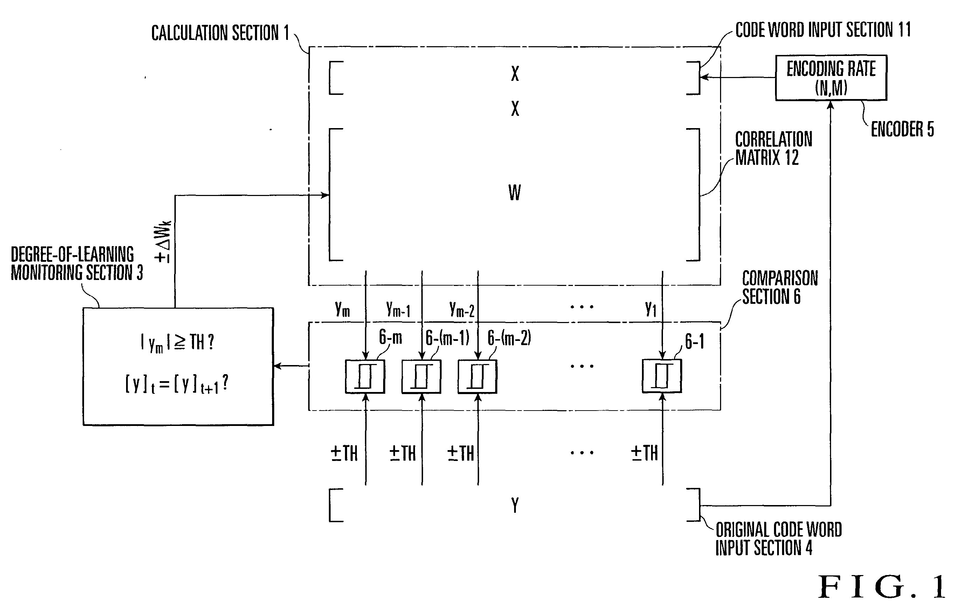

Fig. 1 shows a correlation matrix learning apparatus according to an embodiment of the present invention. The correlation matrix learning apparatus shown in Fig. 1 comprises an original code word input section 4 for inputting an M-bit original code word Y, a code word input section 11 for inputting a block-encoded N-bit code word X with an encoding rate (N,M), a calculation section 1 for calculating the product of the code word X input to the code word input section 11 and an

N (rows) $\times$ M (columns) correlation matrix 12 and outputting calculation results of M columns, a comparison section 6 having M comparison circuits 6-1 to 6-m for comparing the calculation results y of M columns, which are output from the calculation section 1, with threshold values set on the basis of the respective components of the original code word Y, and a degree-of-learning monitoring section 3 for monitoring comparison results from the comparison circuits 6-1 to 6-m of the comparison section 6 and setting an update value "$\Delta W_K$" of the correlation matrix 12, which changes stepwise in accordance with the comparison results. The M-bit original code word Y input to the original code word input section 4 is encoded to the N-bit code word X by an encoder 5 and then input to the code word input section 11.

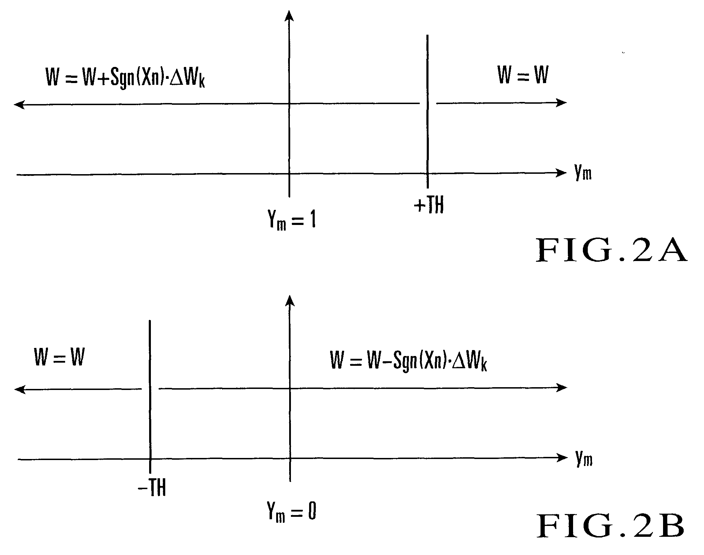

The operation of the correlation matrix learning apparatus having the above arrangement will be described next with reference to Figs. 2 to 4. A correlation matrix W is defined by a learning rule that is predetermined from the calculation results y of the code word X and correlation matrix W using the original code word Y serving as a desired signal.

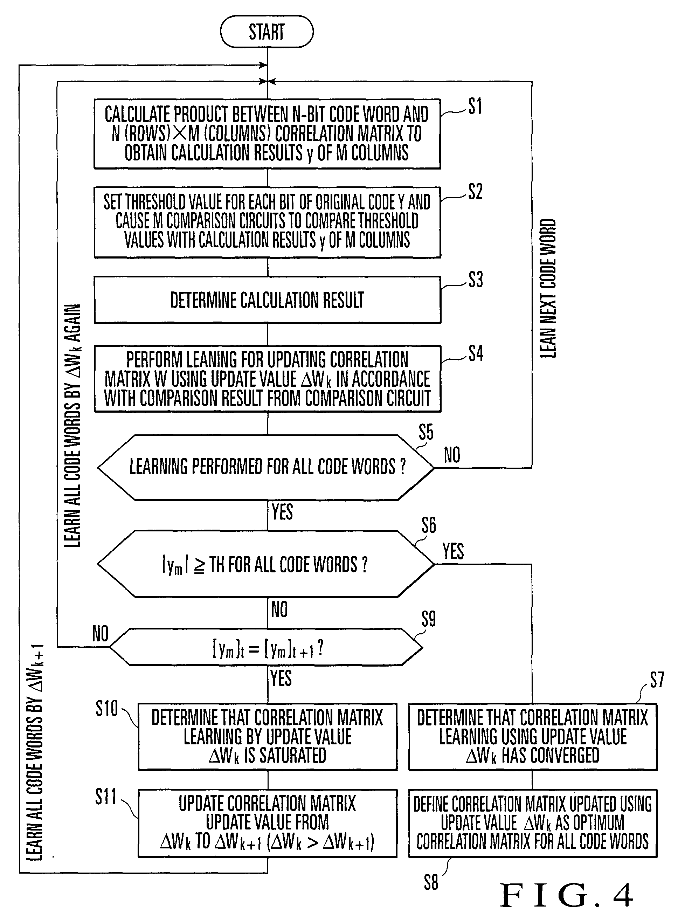

Referring to the flow chart shown in Fig. 4, first, the M-bit original code word Y is input to the original code word input section 4. The encoder 5 executes block-encoding with an encoding rate (N,M) for the original code word Y input to the original code word input section 4 and outputs the encoded N-bit code word X to the code word input section 11. The calculation section 1 calculates the product between the code word X input to the code word input section 11 and the N (rows) $\times$ M (columns) correlation matrix W and outputs the calculation results y to the comparison section 6 (step S1).

The comparison section 6 sets a threshold value for each bit of the original code word Y input to the original code word input section 4 and compares the calculation results y from the calculation section 1 with the respective set threshold values (step S2). In setting a threshold value by the comparison section 6, as shown in Fig. 2, when each bit of the original code word Y is "1", "+TH" is set as a threshold value. On the other hand, when each bit of the original code word Y is "0", "-TH" is set as a threshold value.

When a bit of the original code word Y is "1", and the calculation result y input to the comparison section 6 is equal to or more than "+TH", the correlation matrix W is not updated. If the calculation result y is smaller than "+TH", the correlation matrix W is updated by "$\pm \Delta W_K$". When a bit of the original code word Y is "0", and the calculation result y is equal to or less than "-TH", the correlation matrix W is not updated. If the calculation result y is larger than "-TH", the correlation matrix W is updated by "$\pm \Delta W_K$" (steps S3 and S4).

More specifically, when a bit $Y_m$ of the original code word Y is "1", a threshold value "+TH" is set in the comparison circuit 6-m. At this time, if an input $y_m$ to the comparison circuit 6-m is equal to or more than "+TH", the correlation matrix W is not updated. However, if the input $y_m$ is smaller than "+TH", a correlation matrix $W_m$ is updated in the following way.

$$W_{n,m} = W_{n,m} + Sgn(X_n) \cdot \Delta W_{\underline{K}}$$

$$W_{n-1,m} = W_{n-1,m} + Sgn(X_{n-1}) \cdot \Delta W_K$$

.

.

$$W_{1,m} = W_{1,m} + Sgn(X_1) \cdot \Delta W_K$$

On the other hand, when the bit $Y_m$ of the original code word Y is "0", a threshold value "-TH" is set in the comparison circuit 6-m. At this time, if the input $y_m$ to the comparison circuit 6-m is equal to or less than "-TH", the correlation matrix W is not updated. However, if the input $y_m$ is larger than "-TH", the correlation matrix $W_m$ is updated in the following way.

$$W_{n,m} = W_{n,m} - Sgn(X_n) \cdot \Delta W_K$$

$$W_{n-1,m} = W_{n-1,m} - Sgn(X_{n-1}) \cdot \Delta W_K$$

.

.

$$W_{1,m} = W_{1,m} - Sgn(X_1) \updownarrow \Delta W_K$$

However, when each component $[X_n, X_{n-1}, X_{n-2},..., X_2, X_1]$ of the block-encoded code word X is represented by a binary value "1" or "0", calculation is performed by replacing "0" with "-1". Note that $Sgn(X_n)$ represents the sign ($\pm$) of $X_n$.

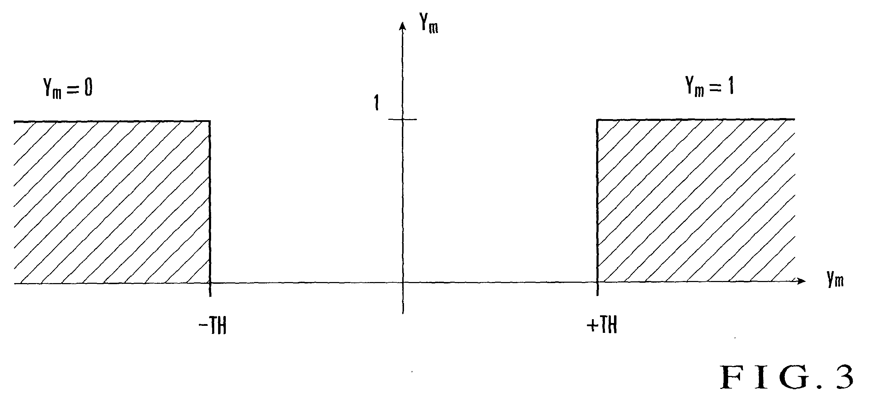

The degree-of-learning monitoring section 3 monitors whether the values of the calculation results y input to the comparison section 6 satisfy $|y_m| \geq TH$ shown in Fig. 3 for all the code words (step S6). The degree-of-learning monitoring section 3 also monitors whether the values of all the M components have changed after learning of one cycle. After the correlation matrix W is learned by updating the correlation matrix W by "$\Delta W_K$" for code words, and the values y of the calculation results in learning the code words at that time satisfy $|y_m| \geq TH$ shown in Fig. 3, it is determined that the degree of learning of the correlation matrix W with the update value "$\Delta W_K$" has converged, and the correlation matrix W to be used for decoding is obtained (steps S7 and S8).

On the other hand, if it is determined in step S6 that the values of the calculation results y do not satisfy the condition shown in Fig. 3 for all the code words, it is monitored whether a value $[y]_{t+1}$ in learning of that cycle is equal to or different from a value $[y]_t$ in learning

of the preceding cycle, i.e., whether $[y]_t = [y]_{t+1}$ (step S9). If the values of the calculation results y for all the code words are not different from the values in learning of the preceding cycle, i.e., $[y]_t = [y]_{t+1}$, it is determined that the degree of learning of the correlation matrix W with the update value "$\Delta W_K$" is saturated (step S10), and the update value of the correlation matrix W is updated from "$\Delta W_K$" to "$\Delta W_{K+1}$" (step S11). After that, the flow returns to step S1 to repeat processing from step S1 using the updated update value "$\Delta W_{K+1}$".

If it is determined in step S9 that $[y]_t \neq [y]_{t+1}$, the flow immediately returns to step S1 to repeat learning for all the code words using "$\Delta W_K$" again. Table 1 shows the relationship between the above-described learning convergence determination condition and the correlation matrix update value.

Table 1

|  | $[y_m]_t = [y_m]_{t+1}$ | $[y_m]_t \neq [y_m]_{t+1}$ |
|---|---|---|
| $\|y_m\| \geq$ TH | Converge | Converge |
| $\|y_m\| <$ TH | $\Delta W_K \rightarrow \Delta W_{K+1}$ | $\Delta W_K$ |

When the correlation matrix W is learned for all the code words X, the correlation matrix W that is optimum for the input value to the comparison section 6 to satisfy the value shown in Fig. 3 can be obtained by a minimum number of times of learning.

The processing shown in the flow chart of Fig. 4 is stored in a storage medium such as a floppy disk, CD-ROM, magnetooptical disk, RAM, or ROM as a correlation matrix learning program. When the correlation matrix learning program stored in such a storage medium is read out and executed by a computer through a drive device, convergence in correlation matrix learning in obtaining, by learning, a correlation matrix optimum for a decoding scheme of obtaining an original code word from a code word can be made faster, and a correlation matrix optimum for all code words can be established.

As described above, according to this embodiment, when the values of the calculation results y do not satisfy the relationship shown in Fig. 3 for all code words, and the values of the calculation results y do not different from those in learning of the preceding cycle, the degree-of-learning monitoring section 3 determines that the degree of learning of the correlation matrix by the update value at that time is saturated, and the correlation matrix update value is changed stepwise. More specifically, the update value of the correlation matrix W is set to "$\Delta W_0$" for learning of the first cycle. As the learning progresses, the update value is changed in a direction in which the update value converges to zero, like "$\Delta W_1$, $\Delta W_2$, $\Delta W_3$,..., $\Delta W_K$, $\Delta W_{K+1}$,... " (TH > $\Delta W_0$ > $\Delta W_1$ > $\Delta W_2$ > $\Delta W_3$ > ... $\Delta W_K$ > $\Delta W_{K+1}$ > ... > 0). In addition, as the learning progresses, the update value is gradually decreased, thereby changing the update value "$\Delta W_K$" stepwise as the learning progresses.

If the values of the calculation results y satisfy the relationship shown in Fig. 3 for all code words, it is determined that the degree of learning by the update value at that time has converged, and update of the correlation matrix is ended. For this reason, a correlation matrix learning method and apparatus capable of obtaining, by a minimum number of times of learning, an optimum correlation matrix W for a correlation matrix in a decoding scheme of decoding a block code using a correlation matrix, and a storage medium therefor can be provided.

As has been described above, according to the present invention, on the basis of a comparison result obtained by comparing the calculation result of a code word and a correlation matrix with a threshold value set for each component on the basis of an original code word, the correlation matrix is updated using an update value which changes stepwise, learning based on the updated correlation matrix is executed for all the code words, and the correlation matrix update value is changed stepwise and, more particularly, changed in a direction in which the update value converges to zero as the learning progresses. With this arrangement, convergence of correlation matrix learning can be made faster, and a correlation matrix optimum for all code words can be established.

In addition, the degree of learning of a correlation matrix is monitored, the update value is changed stepwise when the degree of learning is saturated, and update of the correlation matrix is ended when the degree of learning has converged. Hence, learning more than necessity need not be executed, convergence of correlation matrix learning can be made faster, and a correlation matrix optimum for all code words can be established.

**Claims**

1. A correlation matrix learning method of obtaining an optimum correlation matrix by learning for a correlation matrix in a decoding scheme of obtaining an original code word from a code word, **characterized by** comprising the steps of:

    performing calculation between the code word and the correlation matrix;
    comparing a calculation result with a threshold value set for each component on the basis of the original code word;
    updating the correlation matrix on the basis of a comparison result using an update value which changes stepwise; and
    performing learning of the correlation matrix including calculation, comparison, and update for all code words, thereby obtaining an optimum correlation matrix for all the code words.

**2.** A method according to claim 1, wherein the update step comprises the step of changing the update value stepwise in a direction in which the update value converges to zero.

**3.** A method according to claim 1, further comprising the steps of:

> monitoring a degree of learning of the correlation matrix by the update value;
> when the degree of learning is saturated, changing the update value stepwise;
> update the correlation matrix using the changed update value; and
> when the degree of learning has converged, ending update of the correlation matrix.

**4.** A correlation matrix learning apparatus for obtaining an optimum correlation matrix by learning for a correlation matrix in a decoding scheme of obtaining an original code word from a code word, **characterized by** comprising:

> calculation means (1) for performing calculation between the code word and the correlation matrix;
> comparison means (6) for comparing a calculation result from said calculation means with a threshold value set for each component on the basis of the original code word; and
> degree-of-learning monitoring means (3) for updating the correlation matrix on the basis of a comparison result from said comparison means using an update value which changes stepwise,
>
> wherein said degree-of-learning monitoring means monitors a degree of learning of the correlation matrix by the update value for all code words and controls a change in update value in accordance with a state of the degree of learning.

**5.** An apparatus according to claim 4, wherein said degree-of-learning monitoring means changes the update value stepwise in a direction in which the update value converges to zero.

**6.** An apparatus according to claim 4, wherein said degree-of-learning monitoring means monitors a degree of learning of the correlation matrix by the update value, when the degree of learning is saturated, changes the update value stepwise and updates the correlation matrix using the changed update value, and when the degree of learning has converged, ends update of the correlation matrix.

**7.** A computer-readable storage medium which stores a correlation matrix learning program for obtaining an optimum correlation matrix by learning for a correlation matrix in a decoding scheme of obtaining an original code word from a code word, **characterized in that** the correlation matrix learning program comprises the steps of:

> performing calculation between the code word and the correlation matrix;
> comparing a calculation result with a threshold value set for each component on the basis of the original code word;
> updating the correlation matrix on the basis of a comparison result using an update value which changes stepwise; and
> performing learning of the correlation matrix including calculation, comparison, and update for all code words, thereby obtaining an optimum correlation matrix for all the code words.

**8.** A medium according to claim 1, wherein the correlation matrix learning program further comprises the steps of:

> monitoring a degree of learning of the correlation matrix by the update value;
> when the degree of learning is saturated, changing the update value stepwise;
> update the correlation matrix using the changed update value; and
> when the degree of learning has converged, ending update of the correlation matrix.

EP 1 193 883 A2

CALCULATION SECTION 1

CODE WORD INPUT SECTION 11

$$\begin{bmatrix} & & X & & \\ & & X & & \\ & & & & \\ & & W & & \end{bmatrix}$$

ENCODING RATE (N,M)

ENCODER 5

CORRELATION MATRIX 12

DEGREE-OF-LEARNING MONITORING SECTION 3

$\pm \Delta W_k$

$|y_m| \geqq TH$ ?

$[y]_t = [y]_{t+1}$ ?

COMPARISON SECTION 6

$y_m$    $y_{m-1}$    $y_{m-2}$    $\cdots$    $y_1$

6-m    6-(m-1)    6-(m-2)    $\cdots$    6-1

$\pm TH$    $\pm TH$    $\pm TH$    $\cdots$    $\pm TH$

$$\begin{bmatrix} & & Y & & \end{bmatrix}$$

ORIGINAL CODE WORD INPUT SECTION 4

F I G . 1

EP 1 193 883 A2

$$W = W + \text{Sgn}(X_n) \cdot \Delta W_k \qquad W = W$$

$Y_m$

$Y_m = 1 \qquad +TH$

## FIG.2A

$$W = W \qquad W = W - \text{Sgn}(X_n) \cdot \Delta W_k$$

$Y_m$

$-TH$

$Y_m = 0$

## FIG.2B

EP 1 193 883 A2

F I G . 3

START

CALCULATE PRODUCT BETWEEN N-BIT CODE WORD AND N (ROWS)×M (COLUMNS) CORRELATION MATRIX TO OBTAIN CALCULATION RESULTS y OF M COLUMNS — S1

SET THRESHOLD VALUE FOR EACH BIT OF ORIGINAL CODE Y AND CAUSE M COMPARISON CIRCUITS TO COMPARE THRESHOLD VALUES WITH CALCULATION RESULTS y OF M COLUMNS — S2

DETERMINE CALCULATION RESULT — S3

PERFORM LEANING FOR UPDATING CORRELATION MATRIX W USING UPDATE VALUE $\Delta W_k$ IN ACCORDANCE WITH COMPARISON RESULT FROM COMPARISON CIRCUIT — S4

LEARNING PERFORMED FOR ALL CODE WORDS ? — S5   NO

YES

$|y_m| \geq$ TH FOR ALL CODE WORDS ? — S6   YES

NO

$[y_m]_t = [y_m]_{t+1}$ ? — S9   NO

YES

LEARN NEXT CODE WORD

LEARN ALL CODE WORDS BY $\Delta W_k$ AGAIN

LEARN ALL CODE WORDS BY $\Delta W_{k+1}$

DETERMINE THAT CORRELATION MATRIX LEARNING BY UPDATE VALUE $\Delta W_k$ IS SATURATED — S10

DETERMINE THAT CORRELATION MATRIX LEARNING USING UPDATE VALUE $\Delta W_k$ HAS CONVERGED — S7

UPDATE CORRELATION MATRIX UPDATE VALUE FROM $\Delta W_k$ TO $\Delta W_{k+1}$ ($\Delta W_k > \Delta W_{k+1}$) — S11

DEFINE CORRELATION MATRIX UPDATED USING UPDATE VALUE $\Delta W_k$ AS OPTIMUM CORRELATION MATRIX FOR ALL CODE WORDS — S8

F I G . 4